# EUROPEAN PATENT SPECIFICATION

(11) **EP 0 536 992 B1**
(45) Date of publication and mention of the grant of the patent: **13.05.1998**
(21) Application number: 92309133.4
(22) Date of filing: 07.10.1992
(51) Int. Cl.: H01L 21/768

(54) **Semiconductor planarization process**
Planarisierungsverfahren für einen Halbleiter
Procédé de planarisation d'un semi-conducteur

(30) Priority: 10.10.1991 US 774209
(43) Date of publication of application: 14.04.1993
(73) Proprietor: SGS-THOMSON MICROELECTRONICS, INC., Carrollton Texas 75006 (US)
(72) Inventor: Huang, Kuei-Wu, Irving, Texas 75063 (US)
(74) Representative: Palmer, Roger

(56) References cited:
- EP-A- 0 312 154
- EP-A- 0 416 165
- EP-A- 0 441 653
- US-A- 4 662 064

## Description

This invention relates to improvements in semiconductor fabrication processes, and more particularly to improvements in semiconductor planarization processes, and to semiconductor products utilizing the improved planarization process of the invention.

In the fabrication of integrated circuits in many instances it is desired to provide a planarized surface, that is, a top surface for the integrated circuit that has relatively even or smooth topography.

US 4662064 relates to a method of forming multi-level metallization. A thick layer of planarizing material is applied over a first level of metallization. A photoresist is formed in the depressions on the surface of the planarizing material. The surface of the planarizing material is planarized by an isotropic etch-back, to at least the depth of the planarizing layers's greatest depression. The photoresist is removed. The structure is isotropically etched to expose the first level metallization layer. A layer of oxide is applied to the surface of the resultant structure and a second layer of metallization is applied over the oxide layer.

EP 0312154 relates to a method of forming an interconnection between conductive levels. A passivating material is provided to cover a first conductive level. The passivating material is removed from a contact area on the first conductive level. Spin-on glass is provided over the structure and etched back to expose the contact area. A second conductive level is provided on the structure to make contact with the contact area on the first conductive level.

EP-A-0441653 relates to a method of forming a planar surface. An insulating layer is applied over underlying conductive regions, and the resulting structure is planarized by the application of a planarizing material. An overall etch is performed. In one embodiment only the planarizing material is etched, in a second embodiment both the planarizing material and insulating material are etched. The document teaches that the planarizing material should be chosen to etch at the same rate as the insulating material.

In the light of the above, it is, therefore, an object of the invention to provide an improved process for planarizing the surface of an integrated circuit on which spin-on glass or the like as been applied.

It is another object of the invention to provide a method of the type described in which the etch rate of spin-on glass is not as critical a process parameter as heretofore.

It is another object of the invention to provide a method of the type described which can be used to enhance the yield and reliability for integrated circuits having multilevel metallization.

It is another object of the invention to provide a method of the type described which does not require complete design of additional masks and does not unduly complicate the integrated circuit process flow.

These and other objects, features, and advantages will become apparent to those skilled in the art from the following detailed description when read in conjunction with the accompanying drawing and appended claims.

According to claim 1 of the present invention there is provided a method for planarizing an integrated circuit structure having a spin-on glass layer overlying an oxide layer of an integrated circuit, comprising the steps of:
selectively etching portions of said spin-on glass layer that overlie portions of said oxide layer that have higher elevations than other portions of said oxide layer;
and then etching overall to etch the spin-on glass layer and exposed portions of said oxide layer underlying regions in which said selective etching of the spin-on glass layer occurred.

In accordance with one aspect of the invention, a method for planarizing an integrated circuit structure having a spin-on glass layer overlying an oxide layer of an integrated circuit is presented. The method includes the steps of selectively etching portions of the spin-on glass structure that overlie portions of the oxide layer that have higher elevations than other portions of the oxide layer, and then etching the spin-on glass layer overall. The etching step includes forming a layer of photoresist over the spin-on glass layer, exposing selected areas of the photoresist over the portions of the oxide layer that have higher elevations than other portions of the oxide layer, removing the exposed areas of the photoresist, and etching the spin-on glass layer within the removed areas of the photoresist. The mask used in patterning the photoresist can be the same mask, or its negative, that is used in forming the metalization layer over which the oxide and spin-on glass layers have been formed.

The invention is illustrated in the accompanying drawings in which:

Figures 1a-1f illustrate side elevation cross-sectional views of a portion of an integrated circuit in various stages of fabrication, in accordance with a preferred embodiment of the method of the invention.

Structures in the various figures of the drawing are not drawn to scale, and the sizes and the dimensions of the various parts illustrated have been exaggerated for clarity of illustration and ease of description. Additionally, in the various figures of the drawing, like reference numerals are used to denote like or similar parts.

It should be noted that the process steps and structures herein described do not necessarily form a complete process flow for manufacturing integrated circuits. It is anticipated that the present invention may be practiced in conjunction with integrated circuit fabrication techniques currently used in the art, and only so much of the commonly practiced process steps are included as are necessary for an understanding of the present invention.

A preferred embodiment of the invention is described hereinbelow beginning with a partially completed integrated circuit structure, as shown in Figure 1a. The structure is formed on a substrate 10 (which may itself comprises layers of structure stacked one upon the other, such structures being referred to generally as a substrate), and includes metal lines 11 which may be, for example, aluminium or the like, that serve to interconnect various parts of the integrated circuit components (not shown) that have been previously formed on the stack of underlying structure or substrate 10. A layer of oxide 13 is formed over the surfaces of the metal lines 11 and the surface of the substrate 10 between the metal lines 11. The oxide 13 may be formed, for example, in accordance with various techniques presently known in the art, preferably by plasma-enhanced techniques. The oxide layer 13 is conformal with the hills and valleys over which it is formed; consequently, the oxide layer 13 forms mountain regions overlying the metal lines 11 over which it is formed with respect to the valley regions between the metal lines 11.

A layer of spin-on glass 15 is then formed overall.

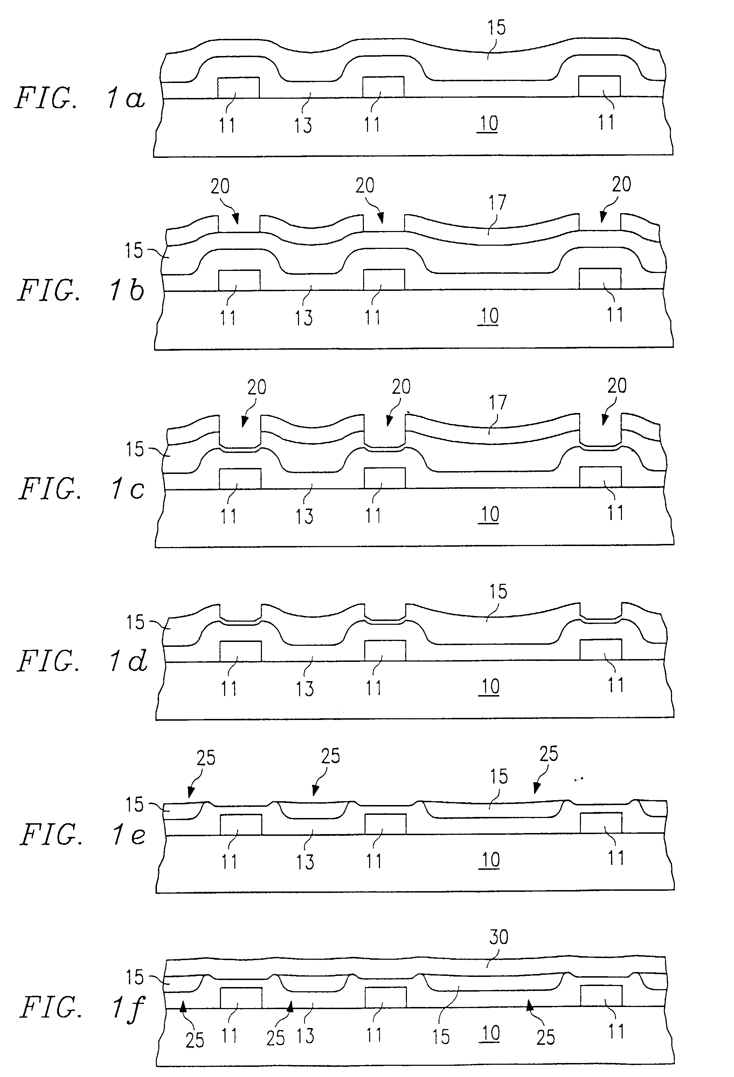

In accordance with the method of the invention, with reference now to Figure 1b, a layer 17 of photoresist is formed and patterned over the layer of spin-on glass 15. A mask, not shown, which may be a reverse or negative mask of the mask used in the formation of the metal lines 11 is used to expose regions 20 of the photoresist layer 17 that overlie the metal lines 11 on the substrate 10. Alternatively, a negative photoresist layer may be used in place of the layer 17 described above, and exposed through the metal mask used in the formation of the metal lines 11, followed by removal of the portions within the regions 20 overlying the metal lines 11 to form the patterned photoresist layer, as shown.

Next, the regions of the spin-on glass 15 and oxide 13 underlying the windows of the photoresist layer 17 are partially etched, as shown in Figure 1c. Figure 1c, schematically illustrates two alternative preferred etch depths, one terminating within the spin-on glass 15 (upper line at the bottom of opening 20) and the other extending through the spin-on glass and terminating within the oxide 13 (lower line at the bottom of opening 20). The exact depth of the etch will be experimentally determined to achieve a planar final result, described below, and may be, for example, to a depth of between 10% and 90%, preferably between 33% and 66%, of the total depth of the layer 15 and oxide 13 overlying the metal lines 11. The etch process may be any commercially known etch, preferably the dry etch to accomplish the etched structure shown.

As shown next in Figure 1d, the layer 17 of photoresist is removed, such as by an ashing process or the like. Finally, as shown in Figure le, the overall structure is exposed to a final planarization etch, which may be, for example, a dry etch, to reduce the thickness of the spin-on glass layer 15 in the regions 25 in the "valleys topography between the metal lines 11. Since the regions overlying the metal lines 11 may have portions of the oxide layer 13 exposed, the etch of the spin-on glass layer 15 in the areas of valley topography will proceed relatively rapidly, but not uncontrollably rapidly. A final integrated circuit structure having a relatively planar surface as shown in Figure 1e can therefore be accomplished. The integrated circuit structure shown in Figure 1e can then be further processed in accordance with known integrated circuit technology for example, by the formation of additional metallization 30 (Figure 1f) planarization, passivation layers and the like.

## Claims

1. A method of planarizing an integrated circuit structure having a spin-on glass layer (15) overlying an oxide layer (13) of an integrated circuit, comprising the steps of:
selectively etching portions of said spin-on glass layer (15) that overlie portions of said oxide layer (13) that have higher elevations than other portions of said oxide layer (13);
and then etching overall to etch the spin-on glass layer (15) and exposed portions of said oxide layer (13) underlying regions in which said selective etching of the spin-on glass layer (15) occurred.

2. The method of claim 1, wherein said oxide layer (13) has been deposited by plasma-enhanced oxide deposition techniques.

3. The method of any preceding claim further comprising providing metal layers (11) under said oxide.

4. The method of claim 1 or 2, wherein said step of selectively etching portions of said spin-on glass layer (15) comprises forming a layer of photoresist (17) over said spin-on glass layer (15), exposing selected areas of said photoresist (20) over said portions of said oxide layer (13) that have higher elevations than other portions of said oxide layer (13), removing said exposed areas (20) of said photoresist (17), and etching said spin-on glass layer (15) within said removed areas (20) of said photoresist (17).

5. The method of claim 3, wherein said step of selectively etching portions of said spin-on glass layer (15) comprises forming a layer of photoresist (17) over said spin-on glass layer (15), exposing selected areas (20) of said photoresist that overlie said metal layers (11), removing said exposed areas (20) of said photoresist, and etching said spin-on glass layer (15) within said removed areas of said photoresist (17).

6. The method of claim 5, wherein said step of exposing selected areas of said photoresist (17) that overlie said metal layers (11) comprises providing a mask that is a negative of a mask used to form said metal layers (11), aligning the mask over the oxide (13) that overlies said metal layers (11), and exposing said layer of photoresist (17) through said mask.

7. The method of claim 5, wherein said step of forming a layer of photoresist (17) over said spin-on glass layer (15) comprises forming a layer of positive resist over said spin-on glass layer (15), and wherein said step of exposing selected areas of said photoresist (17) that overlie said metal layers (11) comprises utilizing a mask that was used to form said metal layers (11), aligning the mask with the oxide (13) that overlies said metal layers (11), and exposing said layer of photoresist (17) through said mask.

8. A method of manufacturing an integrated circuit, comprising:
providing a substrate (10);
forming a first metal interconnection pattern (11) over said substrate for interconnecting selected components of said integrated circuit;
forming an oxide layer (13) over said substrate and said first metal interconnection pattern (11);
forming a layer of spin-on glass material (15) over said oxide layer to form a spin-on glass layer (15);
and planarizing the resultant integrated circuit structure according to the method of claim 1.

9. The method of claim 8, wherein said step of forming an oxide layer (13) over said substrate (10) and said first metal interconnection pattern (11) comprises forming CVD oxide over said substrate (10) and said first metal interconnection pattern (11).

10. The method of claim 8 or 9, wherein said step of selectively etching portions of said spin-on glass layer (15) comprises forming a layer of photoresist (17) over said spin-on glass layer (15), exposing selected areas of said photoresist over said first metal interconnection pattern (11) removing said exposed areas of said photoresist (17), and etching said spin-on glass layer (15) within said removed areas of said photoresist.

11. The method of claim 10, wherein said step of forming a layer of photoresist (17) comprises forming a layer of positive photoresist (17), and wherein said step of exposing selected areas of said photoresist (17) over said first metal interconnection pattern (11) comprises providing a mask that is a negative of a mask to form said metal interconnection pattern (11), and exposing said layer of photoresist (17) through said mask.

12. The method of claim 10, wherein said step of forming a layer of photoresist (17) comprises forming a layer of negative photoresist (17), and wherein said step of exposing selected areas of said photoresist (17) over said first metal interconnection pattern (11) comprises providing a mask used to form said metal interconnection pattern (11), and exposing said layer of photoresist (17) through said mask.

13. The method of any preceding claim wherein said step of selectively etching comprises etching portions of said spin-on glass layer (15), and portions of said oxide layer (13) that have higher elevations than other portions of said oxide layer (13), and which underlie said spin-on glass layer (15).

14. The method of any preceding claim, wherein said step of selectively etching said spin-on glass layer (15) comprises etching between 10 and 90 percent of the thickness of said spin-on glass layer (15) and oxide layer (13).

15. The method of any preceding claim, wherein said step of selectively etching said spin-on glass layer (15) comprises etching between 33 and 66 percent of the thickness of said spin-on glass layer.

16. The method of any preceding claim, wherein said selective etch is a dry etch.

17. The method of any preceding claim, further comprising forming a passivating layer (30) over the spin-on glass layer, after said etch overall.

18. The method of any preceding claim, further comprising forming a second level of metal over the spin-on glass layer (15).

## Patentansprüche

1. Verfahren zum Einebnen bzw. Planarisieren eines Aufbaus einer integrierten Schaltung, die eine aufgeschleuderte Glasschicht (15) hat, die eine Oxidschicht (13) einer integrierten Schaltung überdeckt, das die Schritte aufweist:
Abschnitte der aufgeschleuderten Glasschicht (15), die Abschnitte der Oxidschicht (13) überdecken, die höhere Erhebungen als andere Abschnitte der Oxidschicht (13) haben, werden selektiv geätzt;
und anschließend wird insgesamt bzw. über alles geätzt, um die aufgeschleuderte Glasschicht (15) und freigelegte Abschnitte der Oxidschicht (13) zu ätzen, die den Bereichen unterliegen, in denen das selektive Ätzen der aufgeschleuderten Glasschicht (15) aufgetreten ist.

2. Verfahren nach Anspruch 1, wobei die Oxidschicht (13) durch plasmaverstärkte Oxidabscheidungstechnologien abgeschieden worden ist.

3. Verfahren nach einem der voranstehenden Ansprüche, das ferner aufweist, daß Metallschichten (11) unter dem Oxid vorgesehen werden.

4. Verfahren nach einem der Ansprüche 1 oder 2, wobei der Schritt zum selektiven Ätzen von Abschnitten der aufgeschleuderten Glasschicht (15) aufweist, daß eine Photoresist- bzw. Photolackschicht (17) über der aufgeschleuderten Glasschicht (15) ausgebildet wird, ausgewählte Flächen des Photoresists bzw. Photolacks (20) über den Abschnitten der Oxidschicht (13), die höhere Erhebungen haben als andere Abschnitte der Oxidschicht (13), freigelegt bzw. belichtet werden, die freigelegten bzw. belichteten Flächen (20) des Photolacks bzw. Photoresists (17) entfernt werden, und die aufgeschleuderte Glasschicht (15) innerhalb der entfernten Flächen (20) des Photoresists bzw. Photolacks (17) geätzt werden.

5. Verfahren nach Anspruch 3, wobei der Schritt des selektiven Ätzens von Abschnitten der aufgeschleuderten Glasschicht (15) aufweist, daß eine Schicht von Photoresist oder Photolack (17) über der aufgeschleuderten Glasschicht (15) ausgebildet wird, ausgewählte Flächen (20) des Photoresists bzw. Photolacks freigelegt werden, die die Metallschichten (11) überdecken, die freigelegten Flächen (20) des Photoresists bzw. Photolacks entfernt werden und die aufgeschleuderte Glasschicht (15) innerhalb der entfernten Flächen des Photoresists bzw. Photolacks (17) geätzt wird.

6. Verfahren nach Anspruch 5, wobei der Schritt zum Freilegen bzw. Belichten ausgewählter Flächen des Photoresists bzw. Photolacks (17), die die Metallschichten (11) überdecken, aufweist, daß eine Maskierung bereitgestellt wird, die ein Negativ einer Maske ist, die verwendet wird, um die Metallschichten (11) auszubilden, wobei die Maske über dem Oxid (13) ausgerichtet bzw. angeordnet wird, das die Metallschichten (11) überdeckt und die Schicht des Photoresists bzw. Photolacks (17) wird durch die Maske belichtet bzw. freigelegt.

7. Verfahren nach Anspruch 5, wobei der Schritt zum Ausbilden einer Schicht von Photoresist bzw. Photolack (17) über der aufgeschleuderten Glasschicht (15) aufweist, daß eine Schicht positiven Resists bzw. Photolacks über der aufgeschleuderten Glasschicht (15) ausgebildet wird und wobei der Schritt zum Freilegen bzw. Belichten ausgewählter Flächen des Photoresists bzw. Photolacks (17), die die Metallschichten (11) überdeckt, aufweist, daß eine Maske verwendet wird, die verwendet wurde, um die Metallschichten (11) auszubilden, die die Maske mit dem Oxid (13), das die Metallschichten (11) überdeckt, ausrichtet bzw. anordnet, und die Schicht aus Photolack bzw. Photoresist (17) wird durch die Maske belichtet bzw. freigelegt.

8. Verfahren zur Herstellung einer integrierten Schaltung, das aufweist:
ein Substrat (10) wird bereitgestellt;
eine erste Metallverbindungs- bzw. Zwischenverbindungsstruktur (11) wird über dem Substrat ausgebildet, um ausgewählte Bestandteile der integrierten Schaltung zu verbinden bzw. Zwischenverbindungen herzustellen;
eine Oxidschicht (13) wird über dem Substrat und der ersten Metallzwischenverbindungsstruktur (11) ausgebildet;
eine Schicht von aufgeschleudertem Glasmaterial (15) wird über der Oxidschicht ausgebildet, um eine aufgeschleuderte Glasschicht (15) auszubilden;
und der sich ergebende Aufbau einer integrierten Schaltung wird gemäß dem Verfahren nach Anspruch 1 eingeebnet bzw. planarisiert.

9. Verfahren nach Anspruch 8, wobei der Schritt zum Ausbilden einer Oxidschicht (13) über dem Substrat (10) und der ersten Metallzwischenverbindungsstruktur (11) aufweist, daß ein CVD-Oxid über dem Substrat (10) und der ersten Metallzwischenverbindungsstruktur (11) ausgebildet wird.

10. Verfahren nach Anspruch 8 oder 9, wobei der Schritt des selektiven Ätzens von Abschnitten der aufgeschleuderten Glasschicht (15) aufweist, daß eine Schicht von Photoresist bzw. Photolack (17) über der aufgeschleuderten Glasschicht (15) ausgebildet wird, ausgewählte Flächen des Photoresists bzw. Photolacks über der ersten Metallzwischenverbindungsstruktur (11) belichtet bzw. freigelegt werden, die belichteten Flächen des Photoresists bzw. Photolacks (17) entfernt werden und die aufgeschleuderte Glasschicht (15) innerhalb der entfernten Flächen des Photoresists bzw. Photolacks geätzt werden.

11. Verfahren nach Anspruch 10, wobei der Schritt zum Ausbilden einer Photoresist- bzw. Photolackschicht (17) aufweist, daß eine Schicht von positivem Photoresist bzw. Photolack (17) ausgebildet wird, und wobei der Schritt zum Belichten ausgewählter Flächen des Photoresists bzw. Photolacks (17) über der ersten Metallzwischenverbindungsstruktur (11) aufweist, daß eine Maske bereitgestellt wird, die ein Negativ einer Maske zum Ausbilden der Metallzwischenverbindungsstruktur (11) ist und die Schicht von Photoresist bzw. Photolack (17) durch die Maske belichtet wird.

12. Verfahren nach Anspruch 10, wobei der Schritt zum Ausbilden einer Schicht von Photoresist bzw. Photolack (17) aufweist, daß eine Schicht von negativem Photoresist bzw. Photolack (17) ausgebildet wird, und wobei der Schritt zum Belichten ausgewählter Flächen des Photoresists bzw. Photolacks (17) über der ersten Zwischenmetallverbindungsstruktur (11) aufweist, daß eine Maske bereitgestellt wird, die zum Ausbilden der Metallzwischenverbindungsstruktur (11) verwendet wird, und die Schicht von Photoresist bzw. Photolack (17) durch die Maske belichtet wird.

13. Verfahren nach einem der voranstehenden Ansprüche, wobei der Schritt zum selektiven Ätzen aufweist, daß Abschnitte der aufgeschleuderten Glasschicht (15) und Abschnitte der Oxidschicht (13), die höhere Erhebungen als andere Abschnitte der Oxidschicht (13) haben und die die aufgeschleuderte Glasschicht (15) unterlegen, geätzt werden.

14. Verfahren nach einem der voranstehenden Ansprüche, wobei der Schritt zum selektiven Ätzen der aufgeschleuderten Glasschicht (15) aufweist, daß zwischen 10 und 90% der Dicke der aufgeschleuderten Glasschicht (15) und der Oxidschicht (13) geätzt werden.

15. Verfahren nach einem der voranstehenden Ansprüche, wobei der Schritt zum selektiven Ätzen der aufgeschleuderten Glasschicht (15) aufweist, daß zwischen 33 und 66% der Dicke der aufgeschleuderten Glasschicht geätzt werden.

16. Verfahren nach einem der voranstehenden Ansprüche, wobei die selektive Ätzung eine Trockenätzung ist.

17. Verfahren nach einem der voranstehenden Ansprüche, das ferner aufweist, daß eine Passivierungsschicht (30) über der aufgeschleuderten Glasschicht nach der Gesamt ätzung ausgebildet wird.

18. Verfahren nach einem der voranstehenden Ansprüche, das ferner aufweist, daß eine zweite Metallebene bzw. ein zweites Metallniveau über der aufgeschleuderten Glasschicht (15) ausgebildet wird.

## Revendications

1. Procédé de planarisation d'une structure de circuit intégré munie d'une couche de verre déposée à la tournette (15) recouvrant une couche d'oxyde (13) d'un circuit intégré, comprenant les étapes suivantes ;
graver sélectivement des parties de la couche de verre déposée à la tournette (15) qui recouvre des parties de la couche d'oxyde (13) qui ont des hauteurs plus élevées que d'autres parties de la couche d'oxyde (13) ; et
graver ensuite l'ensemble pour graver la couche de verre déposée à la tournette (15) et des parties exposées des régions sous-jacentes de la couche d'oxyde (13) dans lesquelles la gravure sélective de la couche de verre déposée à la tournette (15) a pris place.

2. Procédé selon la revendication 1, dans lequel la couche d'oxyde (13) a été déposée par des techniques de dépôt d'oxyde assisté par plasma.

3. Procédé selon l'une quelconque des revendications précédentes, comprenant en outre l'étape consistant à prévoir des couches métalliques (11) sous l'oxyde.

4. Procédé selon la revendication 1 ou 2, dans lequel l'étape consistant à graver sélectivement des parties de la couche de verre déposée à la tournette (15) comprend les étapes consistant à former une couche de résine photosensible (17) sur la couche de verre déposée à la tournette (15), à exposer des zones choisies (20) de la photorésine au-dessus des parties de la couche d'oxyde (13) qui ont de plus grandes hauteurs que les autres parties de la couche d'oxyde (13), à enlever les zones exposées (20) de la photorésine (17), et à graver la couche de verre déposée à la tournette (15) dans les zones enlevées (20) de la photorésine (17).

5. Procédé selon la revendication 3, dans lequel l'étape de gravure sélective de parties de la couche de verre déposée à la tournette (15) comprend la formation d'une couche de photorésine (17) sur la couche de verre déposée à la tournette (15), l'exposition de zones choisies (20) de la photorésine qui recouvrent les couches métalliques (11), l'enlèvement des zones exposées (20) de la photorésine et la gravure de la couche de verre déposée à la tournette (15) dans les zones enlevées de la photorésine (17).

6. Procédé selon la revendication 5, dans lequel l'étape d'exposition de zones choisies de la photorésine (17) qui recouvrent les couches métalliques (11) comprend les étapes consistant à prévoir un masque qui est le négatif d'un masque utilisé pour former lesdites couches métalliques (11), à aligner le masque sur l'oxyde (13) qui recouvre les couches métalliques (11), et à exposer la couche de photorésine (17) à travers ledit masque.

7. Procédé selon la revendication 5, dans lequel l'étape de formation d'une couche de photorésine (17) sur la couche de verre déposée à la tournette (15) consiste à former une couche de résine positive sur la couche de verre déposée à la tournette (15), et dans lequel l'étape d'exposition de zones choisies de la photorésine (17) qui recouvrent les couches métalliques (11) comprend l'utilisation d'un masque qui a été utilisé pour former les couches métalliques (11), l'alignement du masque avec l'oxyde (13) qui recouvre les couches métalliques (11), et l'exposition de la couche de photorésine (17) à travers ledit masque.

8. Procédé de fabrication d'un circuit intégré comprenant les étapes suivantes :
prévoir un substrat (10) ;
former un premier motif de métal d'interconnexion (11) sur le substrat pour interconnecter des composants choisis du circuit intégré ;
former une couche d'oxyde (13) sur le substrat et le premier motif de métal d'interconnexion (11) ;
former une couche de matériau vitreux déposée à la tournette (15) sur la couche d'oxyde pour former une couche de verre déposée à la tournette (15) ; et
planariser la structure de circuit intégré résultante selon le procédé de la revendication 1.

9. Procédé selon la revendication 8, dans lequel l'étape de formation d'une couche d'oxyde (13) sur le substrat (10) et le premier motif de métal d'interconnexion (11) comprend la formation d'un oxyde par CVD sur le substrat (10) et le premier motif de métal d'interconnexion (11).

10. Procédé selon la revendication 8 ou 9, dans lequel l'étape de gravure sélective de la couche de verre déposée à la tournette (15) comprend la formation d'une couche de photorésine (17) sur la couche de verre déposée à la tournette (15), l'exposition de la zone choisie du premier motif de métal d'interconnexion (11) pour enlever lesdites zones exposées de la photorésine (17), et la gravure de la couche de verre déposée à la tournette (15) à l'intérieur des zones enlevées de la photorésine.

11. Procédé selon la revendication 10, dans lequel l'étape de formation d'une couche de photorésine (17) comprend la formation d'une couche de photorésine positive (17), et dans lequel l'étape d'exposition de zones choisies de la photorésine (17) sur le premier motif de métal d'interconnexion (11) comprend la prévision d'un masque qui est le négatif d'un masque propre à former le premier motif de métal d'interconnexion (11), et l'exposition de la photorésine (17) à travers ledit masque.

12. Procédé selon la revendication 10, dans lequel l'étape de formation d'une couche de photorésine (17) comprend la formation d'une couche de photorésine négative (17), et dans lequel l'étape d'exposition de zones choisies de la photorésine (17) sur le premier motif de métal d'interconnexion (11) consiste à prévoir un masque utilisé pour former le premier motif de métal d'interconnexion (11) et à exposer la couche de photorésine (17) à travers ledit masque.

13. Procédé selon l'une quelconque des revendications précédentes, dans lequel l'étape de gravure sélective comprend la gravure de parties de la couche de verre déposée à la tournette (15) et de parties de la couche d'oxyde (13) qui ont des hauteurs plus grandes que les autres parties de la couche d'oxyde (13) et qui se trouvent sous la couche de verre déposée à la tournette (15).

14. Procédé selon l'une quelconque des revendications précédentes, dans lequel l'étape de gravure sélective de la couche de verre déposée à la tournette (15) comprend la gravure d'une épaisseur comprise entre 10 et 90 % de l'épaisseur de la couche de verre déposée à la tournette (15) et de la couche d'oxyde (13).

15. Procédé selon l'une quelconque des revendications précédentes, dans lequel l'étape de gravure sélective de la couche de verre déposée à la tournette (15) comprend la gravure d'entre 33 et 66 % de l'épaisseur de la couche de verre déposée à la tournette.

16. Procédé selon l'une quelconque des revendications précédentes, dans lequel la gravure sélective est une gravure à sec.

17. Procédé selon l'une quelconque des revendications précédentes, comprenant en outre la formation d'une couche de passivation (30) au-dessus de la couche de verre déposée à la tournette (15), après la gravure d'ensemble.

18. Procédé selon l'une quelconque des revendications précédentes, comprenant en outre la formation d'un second niveau de métal au-dessus de la couche de verre déposée à la tournette (15).
